# EUROPEAN PATENT APPLICATION

(11) **EP 3 159 910 A1**
(43) Date of publication of application: **26.04.2017**
(21) Application number: 15190491.9
(22) Date of filing: 20.10.2015
(51) Int. Cl.: H01J 37/302, B28B 1/00, B33Y 10/00, C23C 16/04

(54) **ADAPTIVE CONTROL FOR CHARGED PARTICLE BEAM PROCESSING**

(71) Applicant: FEI Company, Hillsboro, OR 97124-5793 (US)
(72) Inventor: STRAW, Marcus, Portland, OR Oregon 97212 (US); RUE, Chad, Portland, OR Oregon 97229 (US); RANDOLPH, Steven, Portland, OR Oregon 97209 (US); BOTMAN, Aurélien, Portland, OR Oregon 97229 (US); CHANDLER, Clive, Portland, OR Oregon 97212 (US); UTLAUT, Mark, Scappoose, OR Oregon 97056 (US)
(74) Representative: Bakker, Hendrik

(57) **Abstract**

An improved process control for a charged beam system is provided that allows the capability of accurately producing complex two and three dimensional structures from a computer generated model in a material deposition process. The process control actively monitors the material deposition process and makes corrective adjustments as necessary to produce a pattern or structure that is within an acceptable tolerance range with little or no user intervention. The process control includes a data base containing information directed to properties of a specific pattern or structure and uses an algorithm to instruct the beam system during the material deposition process. Feedback through various means such as image recognition, chamber pressure readings, and EDS signal can be used to instruct the system to make automatic system modifications, such as, beam and gas parameters, or other modifications to the pattern during a material deposition run.

## Description

### Technical Field of the Invention

The present invention relates generally to a method and apparatus for depositing material in a pattern.

### Background of the Invention

Beam systems, such as electron beam systems, ion beam systems, laser beam systems, cluster beam systems, and neutral particle beam systems, are used to create features on a surface by etching or depositing material. Focused beams are used to remove material from a sample and to deposit material onto the sample. Material can be removed by sputtering, in which the momentum of the particles in the beam physically knock atom or molecules from the sample surface.

A particle or laser beam can be used to induce a chemical reaction. In some cases, the beam induces decomposition of a precursor gas. The precursor gas is preferably stable so that it does not react with the work piece away from the beam impact area. The resolution of the deposit or etching is determined by the beam diameter and region of interaction between the beam and the work piece. "Resolution" is used herein to refer to the smallest feature size that a process can produce.

In beam-induced deposition, the decomposition products include a non-volatile product that remains on the work piece and a volatile product that is eventually removed by the vacuum pump. For example, a gaseous organometallic compound, such as tungsten hexacarbonyl, may be provided near the sample and is adsorbed onto the surface. The beam decomposes the tungsten hexacarbonyl to leave tungsten on the work piece at the points of beam impact.

In beam-induced etching, the precursor gas forms a volatile byproduct with the work piece material, which is eventually removed by the vacuum pump. For example, iodine can be used as a precursor gas to etch silicon, the iodine forming volatile compounds with the silicon in the presence of the beam. Many deposition precursors and etch precursors are known in the art. In some cases, such as a beam of carbon 60 particles, material in the beam are directly deposited onto the surface without disassociating a precursor.

Different types of beams provide different amounts of energy and have different spot sizes at the sample. Higher energies typically correspond to higher etch or deposition rates, but lower resolution. While a charged particle beam can be focused into a much smaller spot than a laser beam, the size of the beam spot on the work piece is typically related to the current in the beam. Beam current is usually determined by the size of an aperture in the beam path. A smaller aperture blocks more of the off-axis particles, which typically do not focus as well as the particles near the axis. Blocking the off-axis particles reduces the beam current. Also, reducing the beam current reduces the tendency of the beam to spread out due to the repulsive force of the charged particles in the beam. Changing the aperture typically requires physically moving a new aperture into the beam path and centering it, which takes some time. In some systems, current may also be controlled by controlling source settings, such as the plasma density or extraction voltage.

A typical focused ion beam system using a liquid metal ion source can produce a current of between about 1 pA to about 100 nA with a spot size of between about 3 nm and 3 mm. A plasma ion focused ion beam source can produce currents between about 1.5 pA to about 1.5 µA with a spot size of between about 4 nm and about 5 mm. Electron beam currents are typically between about 0.5 pA to about 0.5 µA with a spot size from less than a nanometer to about 3 nm. A small, high resolution beam typically has a low current, which produces a low etch or deposition rate. For example, the rate of focused electron beam-induced deposition is typically around about 5 x 10⁻⁴ µm³·nC⁻¹. An ion beam can typically deposit a film using beam-induced deposition at a rate of up to about one micron per minute.

Three-dimensional structures can be formed by multiple scans of the beam, with additional material being etched or deposited on each scan. Each point to which a beam is addressed is referred to as a "dwell point." The period during which a beam remains at a point is referred to as the "dwell period." The total amount of particles or energy provided to a point is referred to as the "dose," and can refer to the dose during a single dwell period, or to multiple dwell periods. A scan may refer to a raster pattern in which the beam scans over a processing area in a regular pattern, such as a rectangle, or may refer to a scan in which the beam is directed toward individual points in an irregular pattern.

A pattern to be fabricated may be represented by a "bitmap," which shows the dwell points to which the beam is to be directed. The beam can be deflected rapidly across points on the work piece that are not to be addressed, or the beam can be blanked between dwell points. To form a pattern of deposited or etched material, current systems allows a user to specify which points on the X,Y plane to expose and a dwell period specified for each point. When the machine operator desires to form a pattern having both large and small features, the operator needs to select a beam that provides sufficient resolution to produce the finer features, which results in an excessive time for forming larger features that do not require fine resolution.

However, two and three dimensional printing with current beam systems require significant user intervention and are limited to thin two-dimensional or simple three-dimensional structures of simple geometric forms, such as, circles and rectangles. Complex three-dimensional structures require significant manual work to define because system technologies are highly variable. Current system technology is affected by both system and sample variables that are not always well controlled, such as, background pressure, sample temperature, age of chemistry, and precursor flux. Such variables may cause small patterning errors that are cumulative and even small deviations at the start of patterning can cause functional or geometrical failure of the desired structure or pattern. For some operating conditions, such as, beam current or beam voltage, the geometry and material properties of any given deposition or etch operation are highly dependent on variables, such as, sample temperature, cleanliness of the sample, vacuum level, residual gas composition, beam profile, and precursor delivery.

What is needed is an improved process control for two and three dimensional material deposition in a beam system to account for technological and system variables to accurately define both two and three dimensional patterns for micro- and nano-scale structures with full automation and minimal user intervention.

### Summary of the Invention

An object of the invention is to provide improved beam processing for two and three dimensional material deposition.

An improved process control for a charged beam system is provided that allows the capability of accurately producing complex two and three dimensional structures from a computer generated model in a material deposition process. The process control actively monitors the material deposition process and makes corrective adjustments as necessary to produce a pattern or structure that is within an acceptable tolerance range with little or no user intervention. The process control includes a data base containing information directed to properties of a specific pattern or structure and uses an algorithm to instruct the beam system during the material deposition process. Feedback through various means such as image recognition, chamber pressure readings, and EDS signal can be used to instruct the system to make automatic system modifications, such as, beam and gas parameters, or other modifications to the pattern during a material deposition run. Additionally, feedback data may be collected and stored in a memory forming a "library" of data for future material deposition runs including such feedback data as sample current to monitor high aspect ratio processes, EDS signal to monitor composition or thickness of a layer, or Raman to quantify when the active component of the structure will be sufficient for the intended purpose. The process control includes data collected from current knowledge of beam deposition experiences to provide detailed mechanisms necessary to implement applications that rely on controlled beam chemistry so that tools "learn" how the changes it makes evolve and can apply the "learning" to future conditions. The active nature of the process to feedback data allows the system to make an informed decision about how to change the patterning process based on prior knowledge. Additionally, the "learning" aspect allows the system to improve decision making or anticipate changes.

In some embodiments, a computer model of a structure to be formed is provided to include specifics of the structure geometry and other structure properties. The computer model is divided into a series of layers each of which includes defined process properties necessary to form each layer. The information for each layer is then consecutively directed to a step that determines specific operations for the beam system to produce a material deposition layer. Each layer is analyzed to determine whether or not its properties fit within acceptable defined tolerances. If it is determined that the layer properties are not within tolerance levels, the system operation instructions are adjusted and the layer is re-executed. This loop continues until the layer fits within acceptable tolerances. Once the layer is analyzed to be acceptable the process continues with the next consecutive layer. After this layer is deposited the steps of analyzing the properties and making any adjustments, if necessary, and re-executing the layer, if necessary, are carried out. This process continues until all layers of the computer model have been formed and the structure or pattern is complete.

In other embodiments, the process control includes all system parameters that are required to form the entire structure, rather than each consecutive layer. After the first layer is formed, it is analyzed to determine if its properties fit within acceptable tolerances. If not, any system adjustments are made until the first layer is acceptable. After the first layer is found to be acceptable, the system is considered to be calibrated to accurately print the entire structure and the remaining layers are then formed without the requirement of being analyzed or any adjustments being made.

In other embodiments, a calibration pattern is created using information from the computer model. The calibration pattern includes data required for each process used in forming the structure. The structure is then formed and analyzed against a predetermined set of tolerances. If it is determined that any part of the structure is out of tolerance, the system parameters are adjusted and the structure is re-formed. This process is repeated until a set of system parameters are found that produce a structure with critical properties that fall within acceptable tolerances.

In other embodiments, each layer is analyzed both during the material deposition process and after completion. The layer is analyzed and the data is fed to one or more memory storage devices for use in the step that determines specific operations for the beam system to produce a material deposition layer. In this embodiment, the algorithm uses data from past processes forming similar patterns as well as data from the current pattern being formed in order to "learn" to automatically adjust when system variables are encountered in future material deposition processes.

In other embodiments, if a layer is determined to be out of tolerance and can be brought into an acceptable tolerance range by material removal, the process controls instruct the beam system to remove any material necessary to bring the layer into acceptable tolerance level and the method can proceed to the next layer.

In other embodiments, the beam current is varied within a single scan during patterning. An analysis of the bitmap is performed to determine which areas of the pattern require a low beam current to produce fine features and which areas of the bitmap can be written at higher beam currents in order to improve throughput. Automatic optimization of the beam path through the bitmap can be achieved by taking into account the trade-off between the time saved from using higher beam currents versus time spent changing the beam current. Embodiments are applicable to fabricating structures using a single scan or to fabricating three-dimensional structures using repeated scans.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention. It should also be realized by those skilled in the art that such equivalent constructions do not depart from the scope of the invention as set forth in the appended claims.

### Brief Description of the Drawings

For a more thorough understanding of the present invention, and advantages thereof, reference is now made to the following descriptions taken in conjunction with the accompanying drawings, in which:
FIG. 1 shows a charged particle beam system that can be used to implement the present invention.
FIG. 2 is a representation of a 3-D CAD model used to form a pattern for 3-D material deposition.
FIG. 3 is schematic of a layer having features of different sizes.
FIG. 4 shows 3-D structures formed from a material deposition process.
FIG. 5 is a flowchart showing the basic steps of implementing the process control in which a structure is formed by consecutive layers.
FIG. 6 is a flowchart showing the basic steps of implementing the process control in which the complete structure is formed without going through the decision loop once the initial layer is within acceptable tolerance.
FIG. 7 is a flowchart directed to another embodiment that incorporates the concepts of "feed-forward" and "feedback."
FIG. 8 is a flowchart directed to another embodiment that incorporates material removal in order to bring a non-conforming layer into acceptable tolerances.
FIG. 9 is a flowchart directed to another embodiment that incorporates a calibration pattern for determining system parameters of the structure after formation of an acceptable first layer.
FIG. 10 is a flow chart showing the steps of implementing the method of determining a beam path during material deposition.
FIG. 11 shows a patterning layer converted to a bitmap, with preferred beam currents for each of the dwell points on the bitmap.
FIG. 12 shows the bitmap of FIG. 11 with the current for each dwell point optimized based on the time to change the current and the preferred current per dwell point.

### Detailed Description of Preferred Embodiments

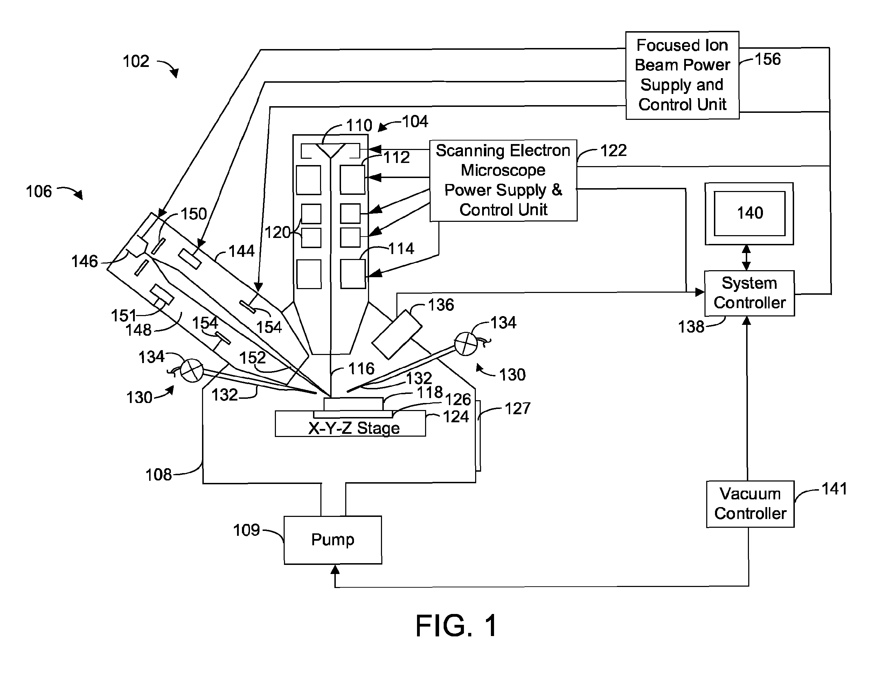

Figure 1 shows a dual beam system 102 that can be used to carry out embodiments of the invention. Suitable beam systems are commercially available, for example, from FEI Company, Hillsboro, Oregon, the assignee of the present invention. While an example of suitable hardware is provided below, the invention is not limited to being implemented in any particular type of hardware.

Dual beam system 102 has a vertically mounted electron beam column 104, and a focused ion beam (FIB) column 106 mounted at an angle of approximately 52 degrees from the vertical on an evacuable specimen chamber 108. The specimen chamber may be evacuated by pump system 109, which typically includes one or more, or a combination of, a turbo-molecular pump, oil diffusion pumps, ion getter pumps, scroll pumps, or other known pumping means.

The electron beam column 104 includes an electron source 110, such as a Schottky emitter or a cold field emitter, for producing electrons, and electron-optical lenses 112 and 114 forming a finely focused beam of electrons 116. Electron source 110 is typically maintained at an electrical potential of between 500 V and 30 kV above the electrical potential of a work piece 118, which is typically maintained at ground potential.

Work piece 118 may be, for example, a semiconductor device, micro-electromechanical system (MEMS), or a lithography mask. The impact point of the beam of electrons 116 can be positioned on and scanned over the surface of the work piece 118 by means of deflection coils 120. Operation of lenses 112 and 114 and deflection coils 120 is controlled by scanning electron microscope power supply and control unit 122. Lenses and deflection unit may use electric fields, magnetic fields, or a combination thereof.

Work piece 118 is on movable stage 124 within specimen chamber 108. Stage 124 can preferably move in a horizontal plane (X and Y axes) and vertically (Z axis) and can tilt approximately sixty (60) degrees and rotate about the Z axis. A door 127 can be opened for inserting work piece 118 onto X-Y-Z stage 124 and also for servicing an internal gas supply reservoir (not shown), if one is used. The door is interlocked so that it cannot be opened if specimen chamber 108 is evacuated. Stage 124 may be cooled, for example, by a Peltier cooler (not shown) or heated by, for example, a resistive heater 126.

Mounted on the vacuum chamber are multiple gas injection systems (GIS) 130 (two shown) for holding the precursor or activation materials and a needle 132 for directing the gas to the surface of the work piece. Each GIS further comprises means 134 for regulating the supply of precursor material to the work piece. In this example the regulating means are depicted as an adjustable valve, but the regulating means could also comprise, for example, a regulated heater for heating the precursor material to control its vapor pressure.

Focused ion beam column 106 comprises an upper neck portion 144 within which are located an ion source 146 and a focusing column 148 including extractor electrode 150 and an electrostatic optical system including an objective lens 151. Ion source 146 may comprise a liquid metal gallium ion source, a plasma ion source, a liquid metal alloy source, or any other type of ion source. The axis of focusing column 148 is tilted 52 degrees from the axis of the electron column. An ion beam 152 passes from ion source 146 through focusing column 148 and between electrostatic deflectors 154 toward work piece 118.

FIB power supply and control unit 156 provides an electrical potential at ion source 146. FIB power supply and control unit 156 is coupled to deflection plates 154 which can cause the ion beam to trace out a corresponding pattern on the upper surface of work piece 118. In some systems, the deflection plates are placed before the final lens, as is well known in the art. Beam blanking electrodes (not shown) within ion beam focusing column 148 cause ion beam 152 to impact onto a blanking aperture (not shown)instead of work piece 118 when a FIB power supply and control unit 156 applies a blanking voltage to the blanking electrode.

System controller 138 controls the operations of the various parts of dual beam system 102. Through system controller 138, a user can cause ion beam 152 or electron beam 116 to be scanned in a desired manner through commands entered into a conventional user interface (not shown). Alternatively, system controller 138 may control dual beam system 102 in accordance with programmed instructions stored in computer memory 140. System controller 138 includes a patterning engine that converts a two or three-dimensional model of a structure into a series of bitmaps and then into electrical signals for controlling the ion beam or electron beam. Computer memory 140 may store instructions for carrying out any of the methods described herein. Figure 1 is a dual beam system shown and described in U.S. Pat. No. 8,853,078, which is assigned to the assignee of this invention and is hereby incorporated by reference, and is just one example of a dual beam system for use with the present invention.

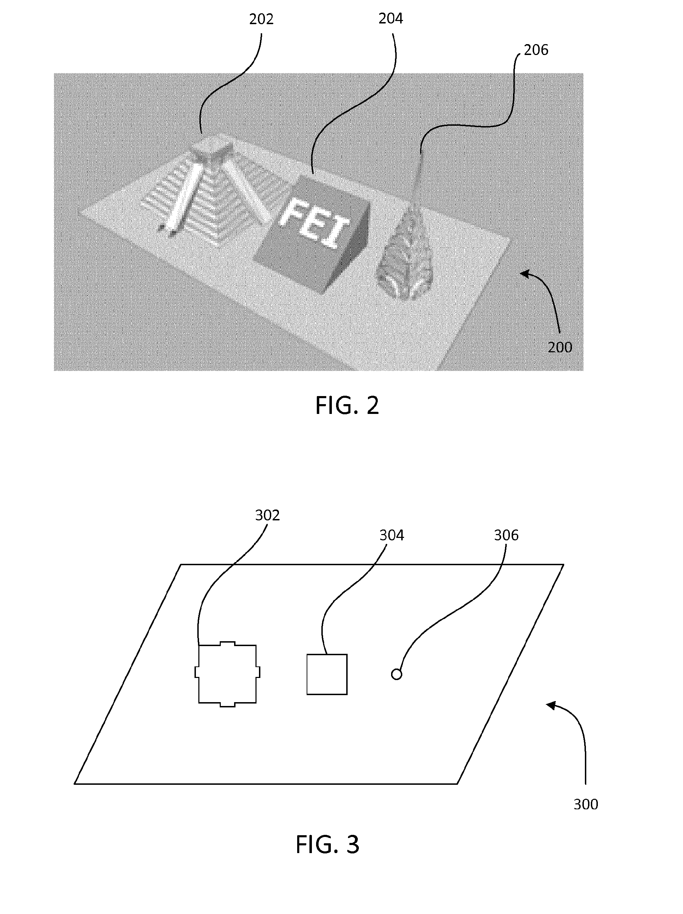

Figure 2 shows a 3-D computer-aided design (CAD) model 200 used to form a 3-D pattern by material deposition. Model 200 includes features 202, 204, 206 of varying shapes and sizes. To produce the three-dimensional bitmap, model 200 may be divided into multiple planar layers, which taken together represent the three dimensional model. Each layer may then be sent to the patterning engine and configured as a bitmap of the desired pattern. This process can be carried out using a GCODE generator program from the ReplicatorG open source 3D printing software that is available at replicat.org/generators, or, if unavailable, at www.archive.org.

Figure 3 shows a bitmap formed from a planar horizontal layer taken from model 200 in which region 302 corresponds to one level of feature 202, region 304 corresponds to one level of feature 204, and region 306 corresponds to one level of feature 206. The patterning algorithm of the beam system determines which points on each of the planar layer to expose to a specific beam current along the beam path. The bitmap is then patterned "written" by either the electron or ion beam, as appropriate. The patterning could formed by depositing material or etching material from the surface, or some combination of the two.

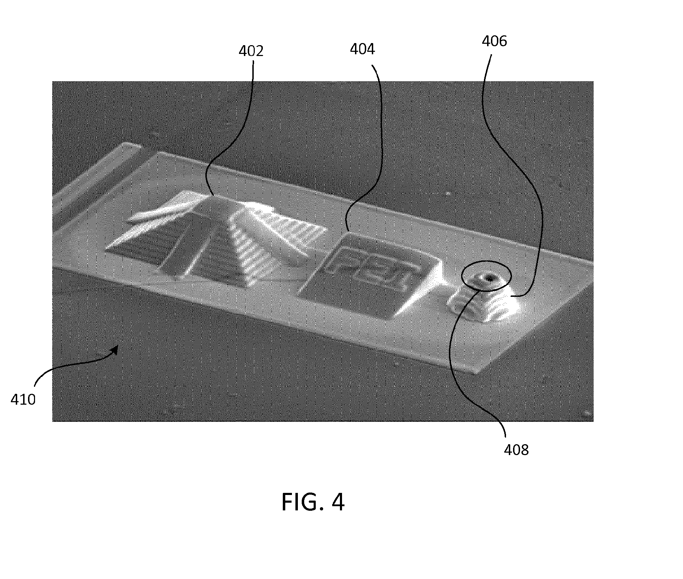

Figure 4 shows an example of a 3-D structure produced from model 200 (Fig. 2) using a prior art method. The model was divided into layers, with a bitmap corresponding to each layer. The same dwell period and beam current is used for all dwell points in each bitmap. The dose, that is, the dwell period times the current, was set at a higher level to reduce processing time. It can be seen, however, that the small spire portion of feature 206 was not formed properly because the dose per pixel was too high. This could have been corrected by setting the global dose lower but the patterning would then have taken much longer. Varying the beam current within the bitmap pattern allows for larger scale features to be formed at a higher current (and a smaller dwell period) while smaller scale features are formed at a lower beam current. This results in higher pattern fidelity with higher throughput.

Other errors may occur since the structure is typically created as each layer is consecutively formed from the "bottom up." Such errors may be caused by uncontrolled variables within either the beam system or the sample, such as, background pressure, sample temperature, precursor flux, vacuum level, residual gas composition, precursor delivery, and beam profile. Patterning errors are cumulative and even small deviations at the start of patterning can cause functional or geometric failure of the desired structure. The process control of this invention accounts for technological and system variables to allow accurate material with full automation and minimal user intervention.

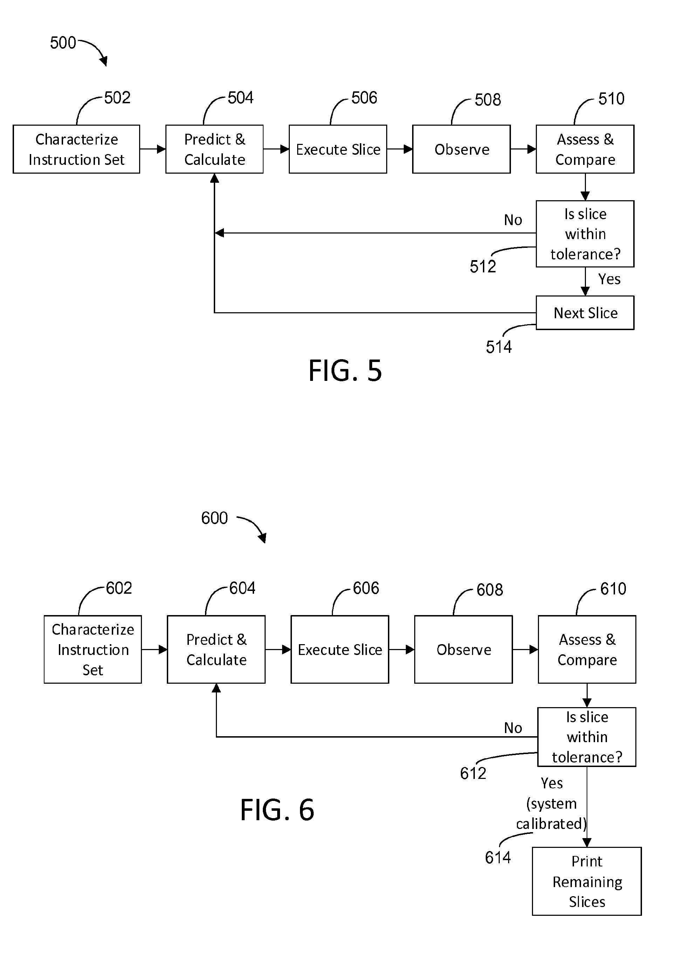

Figure 5 is a flow chart 500 showing the basic steps of implementing the process control. A computer model of a structure to be formed is provided in a "Characterize Instruction Set" in step 502 and includes specifics of the structure geometry and other structure properties, such as, for example, deposit composition and surface roughness tolerance. The computer model is divided into a series of two dimensional layers each of which includes defined process properties necessary to form each layer. Such process properties may include, for example, rastering of a charged particle beam and flow of specific precursor gas. The structure will be formed by depositing each layer from the "bottom up" on an appropriate substrate.

The information for each consecutive layer is then utilized in a "Predict and Calculate" step 504 to determine specific operations for the beam system to produce each layer. For example, based on the specific geometry of each layer and the requirements of the completed structure, a scan strategy and the required system parameters, such as, current, current density (blur or defocus), dwell, overlap, vacuum level, stage temperature, etc., are calculated. In step 504, general instructions for each layer are received as input and instructions for specific tool operations are output to produce the highest fidelity representation of the input as possible. For example, the input might consist of a series of X, Y coordinates where it is desired to obtain a height Z of material added or removed using the charged particle beam as well as specifications on material properties and geometric tolerance. An algorithm uses past knowledge, such as data stored in a look-up table, to achieve this operation. More specifically, it might be known that to obtain an X, Y pixel of Z height consisting of 30 at% Pt, with edge roughness below a given level, the past knowledge advises a combination of beam current, pixel current density, scan strategy (direction and sequence of raster), beam blur or defocus, precursor gas pressure, pixel dwell time, pixel overlap, pixel-to-pixel transit time, chamber base vacuum level, stage temperature, etc. Further examples of known data that is stored for use includes that small scale features or fine features will likely require lower currents (a smaller probe) and different dwell and overlap than larger features. For larger features that don't require dense deposits, beam parameters may be adjusted to ensure rapid deposition to reduce overall printing time. Other deposit characteristics, such as, conductivity, nanostructure, or porosity may be optimized in a similar fashion. Deposition of different materials will require gas changes and still more parameter switches. Scan directions and scan order can be specified to optimize printing layer by layer. For example, features requiring identical beam parameters can be done such that no more than n-1 (where n is the number of different feature types in each layer) parameter changes are required. Etch processes may be interleaved with deposition processes. Each process type should be completed with a minimum number of parameter changes. Sample temperature has been shown to influence growth rate and deposit morphology. Active control of sample temperature or adjustment of other compensating parameters will improve process control and should be implemented. This knowledge is converted into actionable events on the tool.

Using the calculated system parameters of step 504, a layer of material is deposited or "printed" in the "Execute Slice" step 506. The electron or ion beam is rastered in accordance with the pattern calculated in step 504. Optional operations include enabling gas flow for the given gaseous/liquid precursors, moving the stage as necessary, rastering a second charged particle beam (electron or ion), rastering an optical beam, varying dwell time, pixel pitch, beam current or intensity, or other beam parameters.

Once the layer has been formed it is observed in the "Observe" step 508 by using imaging or other in-chamber hardware to record the signals obtained, for either simultaneous or subsequent processing. Examples of such hardware include ETD, TLD, ICE, STEM, or CDEM detectors in SE, BSE, or custom modes; EDX, WDX, or other X-ray detection methods; EBSD detectors in normal or TKD mode; Raman, IR fluorescence imaging or other optical detection methods; AFM or other SPM methods; or sample current monitoring, SE+BSE yield monitoring, or other electron current detection methods.

In the "Assess & Compare" step 510, the critical dimensions or properties of the layer, which may include thickness, are compared to the model and the quality of the layer is assessed against a predetermined set of tolerances. Signals obtained from step 508 are compared to signals expected from step 504 to determine whether or not the critical dimensions or properties of the layer are within expected margins of error or within detection accuracy. For example, the EDX signal could indicate that a layer contains 10 at% Pt, but the model predicted 20 at%. In this case, the comparison reveals that action is necessary because the discrepancy is more than the expected deviation due to EDX detection accuracy (for example, 5 at%). All of the critical properties and critical dimensions as defined in step 504 are assessed. Such properties may include, for example, layer thickness, top surface uniformity, deposit composition, deposit edge wall roughness, the deposit's Young's modulus, etc. Step 512 is a decision block that decides whether or not to proceed to the next layer (step 514) or return to step 504 to calculate a corrective action. If the measured features are determined to be out of tolerance in step 512, the decision loop returns to step 504 where system parameters are adjusted with the direction and amplitude of the adjustments given by prior learning from parametric studies. For example, if the measured layer height is insufficient, then the deposit yield could hypothetically be increased by increasing precursor gas flow or beam current. It should be noted that depending on other system parameters, these same adjustments (increasing precursor gas flow or beam current) may also lead to a further decrease in deposit yield instead. Therefore, the entirety of the parameter set must be considered as a whole, and knowledge gained from multiple loop iterations must be built up to ensure adequate corrective action. A new model is then generated as to what the final layer outcome should resemble. Once this is determined, the layer is re-executed or re-"printed" (step 506) at a different location. The newly formed layer is the observed (step 508) and assessed (step 510). This process is repeated until a set of system parameters are found that produce a slice having critical dimensions that fall within the user specified tolerances. Once the system parameters are set to produce an acceptable layer, the new system parameters are then used to print the next layer in step 514. Each layer is analyzed in steps 508, 510, and 512, and if any layer is outside the acceptable tolerances the decision loop returns to step 504 where any system parameters are adjusted until each layer is acceptable. Each layer is formed consecutively and with each additional layer being printed only after the previous layer is completely finished and acceptable. Once all of the layers are complete, the structure is complete and the process is ended.

Figure 6 is a flow chart 600 showing the steps of implementing the process control similar to the steps set out and described in Fig. 5 except that the decision loop is executed only for the first layer. Once it is determined that the first layer falls within acceptable tolerances then the system is considered to be calibrated for the entire structure and the remaining layers are printed without going through the decision loop. In this embodiment, a computer model of a structure to be formed is provided in a "Characterize Instruction Set" in step 602 and includes specifics of the structure geometry and other structure properties. The computer model is divided into a series of two dimensional layers each of which includes defined process properties necessary to form each layer, which will be deposited consecutively to form the structure. The information for each consecutive layer is then utilized in a "Predict and Calculate" step 604 to determine specific operations for the beam system to produce each layer. Using the calculated system parameters of step 604, a first layer of material is deposited or "printed" in the "Execute Slice" step 606. Once the layer has been formed it is observed in the "Observe" step 608 by using imaging or other in-chamber hardware. In the "Assess & Compare" step 610, the critical dimensions or properties of the layer are compared to the model and the quality of the layer is assessed against a predetermined set of tolerances. Step 612 is a decision block that decides whether or not to proceed to the next layer (step 614) or return to step 604 to calculate a corrective action. If the measured features of the first layer are determined to be out of tolerance in step 612, the decision loop returns to step 604 where system parameters are adjusted. Once new parameters are set, the layer is re-executed or re-"printed" (step 606) at a different location. The newly formed layer is the observed (step 608) and assessed (step 610). This process is repeated until a set of system parameters are found that produce a layer having critical dimensions that fall within the user specified tolerances. It should be noted that the decision loop including steps 602 - 612 are similar to steps 502 - 512 as described in Fig. 5 but are only applied to the first layer. Once the system parameters are set to produce an acceptable first layer, the system is considered to be calibrated for the entire structure and the remaining layers are then printed in step 614 without submitting each layer to the decision loop.

One example of the embodiment of Fig. 6 may include a system in which the stage temperature strongly affects the deposition rate. For instance, a first layer would be printed and assessed to fall outside acceptable tolerances. If it is determined that the stage temperature is the main contributor to the variation in the deposition rate then it is reasonable to assume that stage temperature it will not vary significantly further over the course of executing the remaining layers. Once any necessary system adjustments are then made to produce an acceptable first layer the remaining layers may be printed without verification.

As another example of the embodiment of Fig. 6, the deposited material shape might be strongly dependent on gas pressure if, for example, the deposition is done in a "gas shadowed" region. Here, the first layer would quantify the actual obtained deposition yield for the structure and the parameters, such as deposition time, would be adjusted for all subsequent layers without the need for verification of each layer.

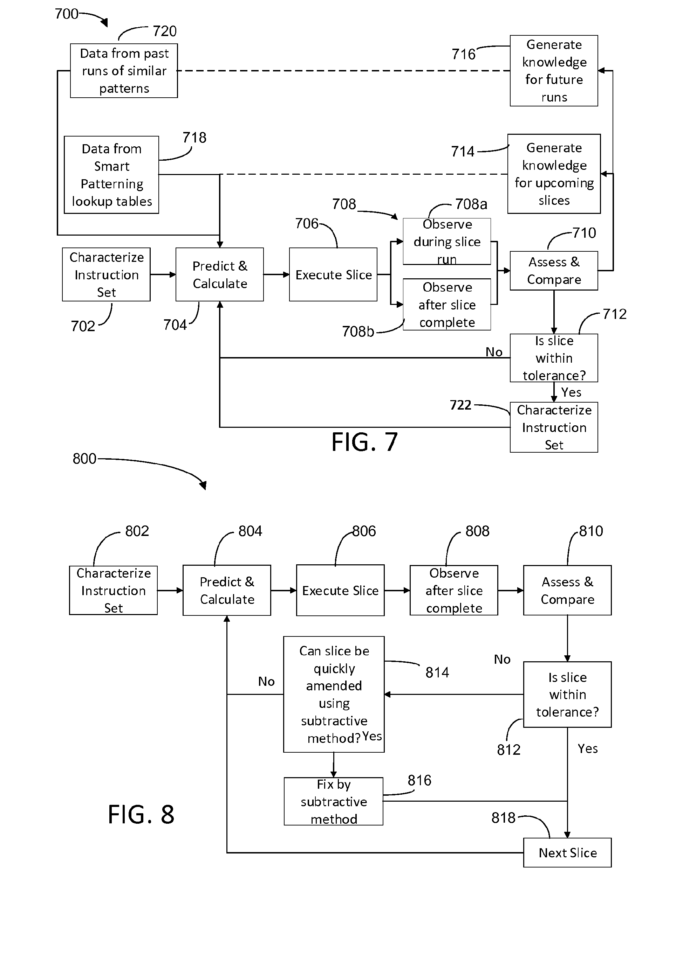

Figure 7 shows a flowchart directed to the concepts of "adaptive learning" and "feed-forward." In this embodiment, both slow and fast changes in the parameter space can be accommodated through a combination of "feed-forward" and "model-based (data-informed) prediction" (or "feedback") aspects, where both predictive and reactive components are required. For example, a slow evolving trend might include a gas precursor crucible might be nearing end of life, giving less and less partial pressure in the chamber for identical conditions. The algorithm in the "Predict & Calculate" step can be trained to recognize this slow decay and the "feed-forward" aspect would adapt future patterns based on a predicted crucible end of life decay rate. Concurrently, the "feedback" aspect is utilized in which day-to-day variability in parameters (such as sample temperature) would add a fast-varying component to the deposition rate. In other words, data or "feedback" from the pattern currently being deposited is transmitted to the algorithm, which incorporates the "feedback" data to recognize fast-changing trends and compensate accordingly. Therefore, both "feed-forward" and "feedback" aspects are required for both short and long timescales for predictive and reactive capabilities.

Figure 7 is a flow chart 700 showing the steps of implementing the process control that incorporate both "feed-forward" and "feedback" aspects to allow the process control to adaptively learn what system parameters need to be incorporated into the algorithm in the "Predict & Calculate" step to predict what system parameters are required to form specific patterns as well as what system parameters need to be adjusted during the deposition cycle. In this embodiment, a computer model of a structure to be formed is provided in a "Characterize Instruction Set" in step 702 and includes specifics of the structure geometry and other structure properties. The computer model is divided into a series of two dimensional layers each of which includes defined process properties necessary to form each layer, which will be deposited consecutively to form the structure. The information for each consecutive layer is then utilized in a "Predict and Calculate" step 704 to determine specific operations for the beam system to produce each layer. Using the calculated system parameters of step 704, a first layer of material is deposited or "printed" in the "Execute Slice" step 706.

Once the layer has been formed it is observed in the "Observe" step 708 by using imaging or other in-chamber hardware. In step 708, the layer is observed both as material deposition occurs (step 708a) and after the layer is complete (step 708b). In the "Assess & Compare" step 710, the critical dimensions or properties of the layer are compared to the model and the quality of the layer is assessed against a predetermined set of tolerances. Step 712 is a decision block that decides whether or not to proceed to the next layer (step 722) or return to step 704 to calculate a corrective action. If the measured features of the first layer are determined to be out of tolerance in step 712, the decision loop returns to step 704 where system parameters are adjusted. Once new parameters are set, the layer is re-executed or re-"printed" (step 706) at a different location. The newly formed layer is the observed (step 708) and assessed (step 710). This process is repeated until a set of system parameters are found that produce a layer having critical dimensions that fall within the user specified tolerances. It should be noted that the decision loop including steps 702 - 712 are similar to steps 502 - 512 as described in Fig. 5 but are only applied to the first layer. Once the system parameters are set to produce an acceptable layer, the new system parameters are then used to print the next layer in step 722. Each layer is analyzed in steps 708, 710, and 712, and if any layer is outside the acceptable tolerances the decision loop returns to step 704 where any system parameters are adjusted until each layer is acceptable. Each layer is formed consecutively and with each additional layer being printed only after the previous layer is completely finished and acceptable. Once all of the layers are complete, the structure is complete and the process is ended.

The embodiment of Fig. 7 further includes steps directed to the adaptive learning concept using "feed-forward" and "feedback." Steps 714 and 716 are directed to the "adaptive learning" concept. More specifically, in step 714 data obtained for each completed layer in the "Observe" step 708 and computed during the "Assess & Compare" step 710 is incorporated into new system rules and formulated as parameter relationships in a data memory storage at step 718. One example of such data might be that a specific sample temperature results in a lower than usual deposition rate, which is useful information in forming subsequent layers. Core knowledge of the interaction between parameters is stored in look-up tables (step 718). For example, for a specific beam energy, current, and dwell time, the look-up tables provide instructions directed to the typical pitch needed to obtain a desired deposit smoothness. This knowledge is then incorporated into the algorithm used in the "Predict & Calculate" step 704. In step 716, data obtained for each completed layer in the "Observe" step 708 and computed during the "Assess & Compare" step 710 is incorporated into new system rules and formulated as parameter relationships in a data memory storage at step 720. This step is better suited to slowly-varying changes in the parameter space. For example, a specific GIS precursor gas crucible might be nearing end of life, which physically translates to a lower gas pressure at the sample. This longer-term information is incorporated as stored knowledge (step 720) for future runs as well as the current run. Step 720 also represents a look-up table for parameter combinations that stores actual data. The data is obtained through multiple runs by saving the information obtained from step 716. The data includes all slowly varying system changes, which can be on a scale of days to months. One example of such data is the state of the GIS gas precursor crucible. The data from the look-up table of step 720, combined with data from step 718, is fed forward for use in the "Predict & Calculate" step 704.

An advantage of the embodiment of Fig. 7 is that it provides an "intelligent" control that "learns" not only from data obtained from past knowledge but also from data obtained during a run. Such "intelligence" allows the controls to determine optical system parameters and also to make adjustments "on the fly" as material deposition occurs. For example, prior to a run, knowledge from look-up tables and data from prior runs is used to determine optimal parameters. Further, at the completion of each layer, the new data resulting from the output actually produced is used to generate knowledge that can be applied both to subsequent layers and to subsequent future runs. This embodiment provides the ability to gather feedback data both at the completion of a layer (image recognition/processing, EDS, Raman analysis) but also during the production of the layer (monitoring of stage current, chamber gas pressure, and sample temperature)

Figure 8 is a flowchart 800 directed to another embodiment that incorporates material removal in order to bring a non-conforming layer into acceptable tolerances. In this embodiment, the decision loop includes a "shortcut" in situations in which it is determined that removing material in order to bring a defective or non-conforming layer into acceptable tolerances would be faster than proceeding through the decision loop. However, the data gathered during the "Predict & Calculate" step is still used in the "learning" process so that future runs do not require the material removal correction step.

In this embodiment, a computer model of a structure to be formed is provided in a "Characterize Instruction Set" in step 802 and includes specifics of the structure geometry and other structure properties. The computer model is divided into a series of two dimensional layers each of which includes defined process properties necessary to form each layer, which will be deposited consecutively to form the structure. The information for each consecutive layer is then utilized in a "Predict and Calculate" step 804 to determine specific operations for the beam system to produce each layer. Using the calculated system parameters of step 804, a first layer of material is deposited or "printed" in the "Execute Slice" step 806.

More specifically, Fig. 8 includes steps 802-812 that are similar to corresponding steps discussed in the above embodiments. If it is determined in step 812 that the layer is not within acceptable tolerance levels, the system determines whether or not the layer can be quickly corrected by material removal to bring the layer to within acceptable dimensions. Such material removal can be done rapidly by applying an ion beam in specific pixels with specific dwell times to remove any excess material so that the original layer specifications are obtained. For example, material removal corrections may include lateral dimension corrections or deposit sidewall straightening. If it is determined that quick material removal is not acceptable, the system returns to steps 804-812 and the process is repeated until it is determined either that the layer is acceptable or, if not, material removal is the best option (step 814) and material removal is carried out (step 816) before proceeding to the next layer in step 818. The decision loop then proceeds for each consecutive layer until the structure is complete and the process is ended.

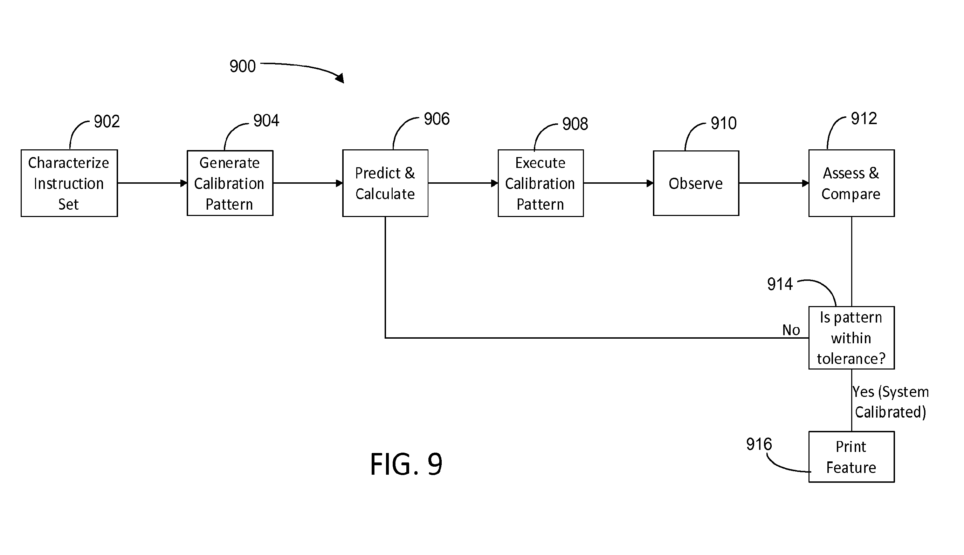

Another embodiment is shown and described in Fig. 9 in which a calibration pattern is generated either manually by the user or, preferably, automatically from the instruction set. The calibration pattern consists of features representative of each process required to print the entire structure. In other words, instead of using the first layer as the calibration with the remaining layers deposited without further verification (as shown and discussed regarding Fig. 6), this embodiment includes a calibration pattern that defines the entire structure. For example, if a pattern consists of a large number of repeating identical units, the calibration patter could be one of those units. A more specific example may include a three-dimensional structure that contains an overhangs. With this structure, a calibration pattern would be generated that contains elements representative of the entire structure against which to perform a parameter calibration. It may be possible that the calibrations needed for the entire final structure can be computationally condensed to one that requires significantly less time to perform and calibrate to rather than a trial-and-error approach of the entire structure. In this example, the system would know that the fabrication of such overhangs is critically dependent not only on the exact ratio of beam current to precursor gas present, but also on other more variable factors such as chamber temperature, previous precursor gas load from prior processing, and sample history, for example. The system would then recognize that a test feature containing a similar overhang may be beneficial to execute and calibrate against to achieve an optimal time-to-final pathway.

Flowchart 900 begins with step 902 in which a computer model of a structure to be formed is provided in a "Characterize Instruction Set" and includes specifics of the structure geometry and other structure properties. The computer model is divided into a series of two dimensional layers each of which includes defined process properties necessary to form each layer, which will be deposited consecutively to form the structure. Information from the instruction set (step 902) is used to generate a calibration pattern in step 904. The information from the calibration pattern (step 904) is then utilized in a "Predict and Calculate" step 906 to determine specific operations for the beam system to produce the structure. Using the calculated system parameters of step 906, the entire structure is formed in the "Execute Calibration Pattern" step 908. Once the structure has been formed it is observed in the "Observe" step 910 by using imaging or other in-chamber hardware. In the "Assess & Compare" step 912, the critical dimensions or properties of the structure are compared to the model and the quality of the structure is assessed against a predetermined set of tolerances. Step 914 is a decision block that decides whether or not to proceed to step 916 or return to step 906 to calculate a corrective action. If the measured features of the structure are determined to be out of tolerance in step 914, the decision loop returns to step 906 where system parameters are adjusted. Once new parameters are set, the calibration pattern is re-executed or re-"printed" (step 908) at a different location. The newly formed calibration pattern is the observed (step 910) and assessed (step 912). This process is repeated until a set of system parameters are found that produce a calibration pattern having critical dimensions that fall within the user specified tolerances.

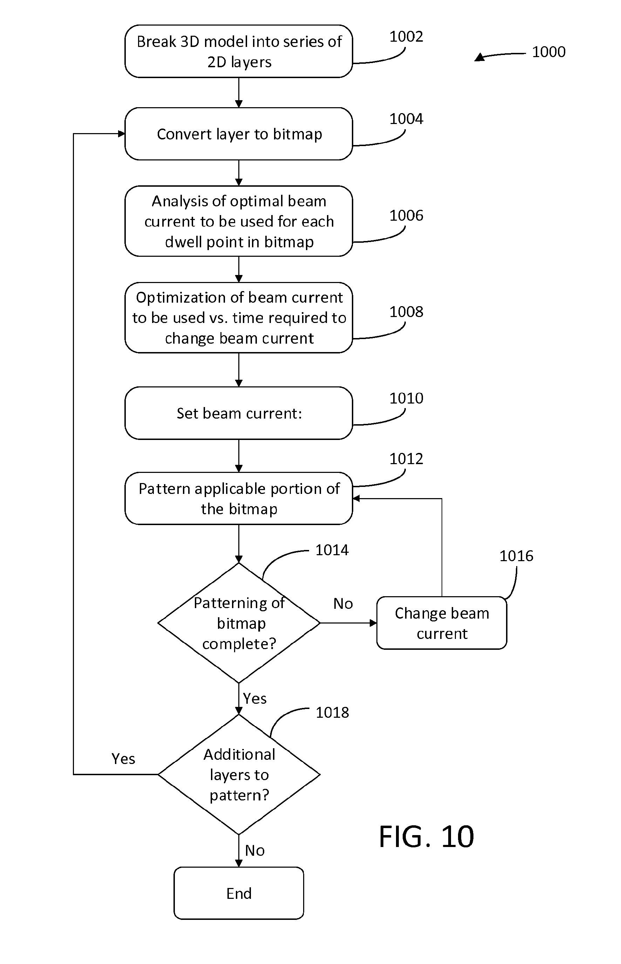

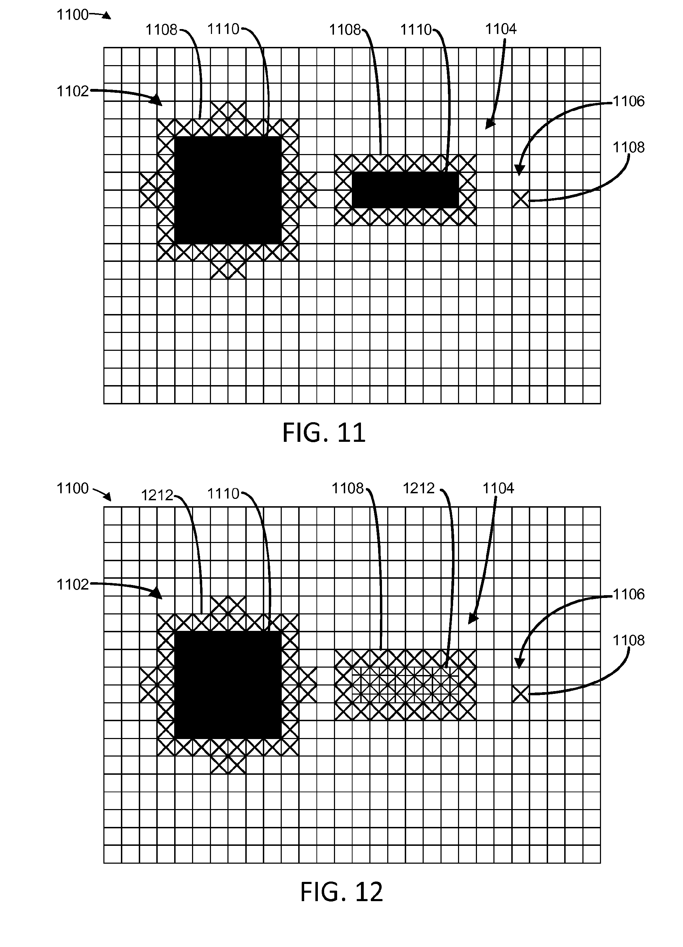

Figures 10 and 11 are directed to another embodiment directed to determining a beam path during material deposition in the "Characterize Instruction Set" and "Predict & Calculate" steps of the previous embodiments. A typical pattern to be fabricated using beam processing may include features of varying size. When patterning a work piece using a charged particle beam, the maximum beam current per pixel is typically determined by the user for the smallest isolated feature that is desired to be fabricated. The beam current used for the smallest features is then applied to the entire pattern, which results in that any large area features would be deposited using the same beam current as the smallest features. This substantially increases the time required to pattern larger areas. Thus, in current systems the beam dwell time can be varied depending on the size of the feature; however, the beam current remains constant resulting in longer processing time than is optimal. To overcome this problem some embodiments vary the beam current within a single scan when the time saved by a larger beam current outweighs the time required to change the beam current.

In this embodiments, a method is provided for planning a beam path for material deposition in a structure pattern to be fabricated. The structure pattern is analyzed to determine the size of the features in the structure pattern. A beam path throughout the structure pattern is configured and the beam current required for each point in the structure pattern is determined. The structure pattern may have features of differing sizes with some features being larger, in area or in volume, than others. The beam current may be varied along the beam path depending on the size of the feature. Configuring the beam current required for each point involves determining the acceptable beam current for that point. For example, material deposition for relatively small features requires low beam current for high accuracy; whereas, relatively large features can be deposited using a higher beam current for faster deposition. Each feature in the structure pattern is deposited at the highest beam current acceptable to allow accurate deposition of the feature. The structure pattern may include multiple planar layers each of which is deposited in a single scan of the beam.

In one embodiment of the invention, a required beam dose for each dwell point is determined by the patterning engine. The patterning engine then determines how the dose is achieved by setting a combination of the current and the dwell period to achieve the dose. The beam scans all the high current pixels in a layer and then scans all the low current pixels. When the spot size needs to be small or can be large without consequences, it is preferable to change the beam current because throughput is increased. It is preferable to adjust the dwell time when having a large spot size is undesirable. For example, region 306 (Fig. 3) represents the small spire of feature 206 (Fig. 2). Typically, smaller features require a lower beam current to achieve accurate material deposition. Larger features, such as region 302 (Fig. 3) can be deposited with a higher beam current, which can provide a higher dose with a shorter dwell time. Setting the global dose lower would result in accurate material deposition; however, this would substantially increase the production time on the order of several hours. A higher global dose reduces processing time but errors can occur resulting in an inaccurate material deposition.

Fig. 10 shows a flow chart 1000 describing the steps of an embodiment of the invention. In step 1002, a three-dimensional model is broken down into layers. In step 1004, a bitmap is created corresponding to the first layer. In step 1006, each of the dwell points on the bitmap is analyzed to determine an optimal beam current and dwell time for that dwell point. The optimal current is determined by the surrounding dwell points. FIG. 11 shows a bitmap 1100 having features 1102, 1104, and 1106. Dwell points 1108 shown in cross hatching are optimally written using a low beam current and dwell points 1110 shown in solid black are optimally to be written with a high beam current. Various methods can be used to determine the optimal beam current for each dwell point. Dwell points within a certain number of dwell points from the edge of the feature are preferably written using a low beam current to define a sharp edge to the feature. In FIG. 11, dwell points that touch the edge or that have a corner touching the edge of the feature are written with a low current.

Depending on the beam system, it may take between about one minute and five minutes to change the current by physically changing the beam-defining aperture in the beam path. It is therefore not efficient to apply the beam currents and dwell times calculated in step 1006 and shown in FIG. 11. For example, in a focused ion beam system using a plasma ion source, a high beam current is typically between about 100 pA and about 1 mA using a beam-defining aperture (BDA) having a diameter of between about 1 µm and 1 mm, with a typical operation having a current of about 1 µA using a BDA having a bore diameter of about 100 µm. A low current may be between about 1 pA and 100 nA, using a BDA having a diameter of between about 1 µm and 1000 µm, with a typical operation having a beam current of about 80 nA using a BDA diameter of about 100 µm.

If the dwell period is 3 ms and the current is increased by a factor of 15, the dwell period can be reduced to 200 ns (3 ms x 1/15) to deliver the same dose, a time saving of 2.8 ms. To recover the time required to change the aperture, for example, 60 seconds, the number of dwell points benefitting from the higher current would need to be at least 60 seconds divided by 2.8 ms, or 21,500 dwell points. For example, a pattern consists of not a single pass but multiple thousands of passes. For a pattern or layer with 1,000 passes, consisting of 500x500 pixels, equates to 250 million total dwell points, making the beam current switch very time effective. As discussed above, the entire pattern or structure which is desired to be written is split into layers. The layer thickness is targeted to be 10-50 nm depending on desired pattern fidelity. Therefore a pattern may have, say, 100 layers, and each layer will have the beam pass over it say from tens to thousands of times.

In step 1008, the beam currents and dwell times to be used at each dwell point are determined by balancing the increased throughput from increasing the beam current against the time required to change the current.

Figure 12 shows, for example, that the dwell points 1212, shown with a cross pattern, although optimally patterned using a high beam current, will be patterned using a low beam current because the reduced dwell time does not compensate for the time required to change the aperture.

In step 1010, a beam is set and the portion of the pattern that is to be scanned at that beam current is scanned in step 1012. If the patterning of that lawyer is determined to not yet be complete in decision block 1014, then the beam current is changed in block 1016 and the work piece is patterned again in step 1012 at the new beam current. If it is determined in decision block 1014 that the patterning of the layer is complete, it is determined in decision block 1018 whether there are additional layers to pattern. If so, the next layer is converted to a bitmap in step 1004 and the process repeats. When it is determined in decision block 1018 that all layers have been patterned, the process is ended.

Preferably, breaking the model into layers and converting the layers into bitmaps is performed automatically by the system controller or another computer. While the model shown in FIG. 2 is produced by beam-induced deposition, other embodiments use beam-induced etch.

While the example describes switching between two current levels, other embodiments can use 3, 4 or more current levels, including in some embodiments a continuous range of current values. It is also known that the beam current can determine whether material is deposited in the presence of a precursor gas or etched. A large current can exhaust the precursor gas adhered to the substrate and remove substrate material faster than material is deposited. Changing the beam current can be used to in some embodiment to switch from a deposition process to an etch process.

A preferred method or apparatus of the present invention has many novel aspects, and because the invention can be embodied in different methods or apparatuses for different purposes, not every aspect need be present in every embodiment. Moreover, many of the aspects of the described embodiments may be separately patentable. The invention has broad applicability and can provide many benefits as described and shown in the examples above. The embodiments will vary greatly depending upon the specific application, and not every embodiment will provide all of the benefits and meet all of the objectives that are achievable by the invention.

It should be recognized that embodiments of the present invention can be implemented via computer hardware, a combination of both hardware and software, or by computer instructions stored in a non-transitory computer-readable memory. The methods can be implemented in computer programs using standard programming techniques-including a non- transitory computer-readable storage medium configured with a computer program, where the storage medium so configured causes a computer to operate in a specific and predefined manner-according to the methods and figures described in this Specification. Each program may be implemented in a high level procedural or object oriented programming language to communicate with a computer system. However, the programs can be implemented in assembly or machine language, if desired. In any case, the language can be a compiled or interpreted language. Moreover, the program can run on dedicated integrated circuits programmed for that purpose.

Further, methodologies may be implemented in any type of computing platform, including but not limited to, personal computers, mini-computers, main-frames, workstations, networked or distributed computing environments, computer platforms separate, integral to, or in communication with charged particle tools or other imaging devices, and the like. Aspects of the present invention may be implemented in machine readable code stored on a non-transitory storage medium or device, whether removable or integral to the computing platform, such as a hard disc, optical read and/or write storage mediums, RAM, ROM, and the like, so that it is readable by a programmable computer, for configuring and operating the computer when the storage media or device is read by the computer to perform the procedures described herein. Moreover, machine-readable code, or portions thereof, may be transmitted over a wired or wireless network. The invention described herein includes these and other various types of non- transitory computer-readable storage media when such media contain instructions or programs for implementing the steps described above in conjunction with a microprocessor or other data processor. The invention also includes the computer itself when programmed according to the methods and techniques described herein.

Computer programs can be applied to input data to perform the functions described herein and thereby transform the input data to generate output data. The output information is applied to one or more output devices such as a display monitor. In preferred embodiments of the present invention, the transformed data represents physical and tangible objects, including producing a particular visual depiction of the physical and tangible objects on a display.

Although much of the previous description is directed at mineral samples from drill cuttings, the invention could be used to prepare samples of any suitable material. The terms "work piece," "sample," "substrate," and "specimen" are used interchangeably in this application unless otherwise indicated. Further, whenever the terms "automatic," "automated," or similar terms are used herein, those terms will be understood to include manual initiation of the automatic or automated process or step.

In the following discussion and in the claims, the terms "including" and "comprising" are used in an open-ended fashion, and thus should be interpreted to mean "including, but not limited to ...." To the extent that any term is not specially defined in this specification, the intent is that the term is to be given its plain and ordinary meaning. The accompanying drawings are intended to aid in understanding the present invention and, unless otherwise indicated, are not drawn to scale. Particle beam systems suitable for carrying out the present invention are commercially available, for example, from FEI Company, the assignee of the present application.

In an embodiment, a method of forming a structure by depositing material onto a work piece in a charged particle system is provided, comprising:
providing a model structure pattern having features;
converting the model structure pattern into a series of layers;
calculating a beam scan strategy and system parameters based on the geometry of each layer;
depositing material corresponding to the first layer of the pattern;
imaging the first material layer;
characterized by comparing the properties of the first material layer with the model structure pattern to determine that the quality of the first material layer based on a predetermined set of values that fits within acceptable specified tolerances.

In some embodiments, the method of forming a structure by depositing material onto a work piece further comprises comparing the properties of the first material layer with the model structure pattern to determine that the quality of the first material layer based on a predetermined set of values that fits within acceptable specified tolerances.

In some embodiments, the method of forming a structure by depositing material onto a work piece further comprises depositing, imaging, and comparing consecutive material layers until the structure is complete.

In some embodiments, the method of depositing, imaging, and comparing consecutive material layers further comprises adjusting any system parameters for each consecutive layer required to produce a material layer that fits within acceptable specified tolerances and depositing each consecutive layer using the adjusted parameters corresponding to each layer.

In some embodiments, the system parameters include at least one of beam current, beam density, dwell time, vacuum level, and temperature.

In some embodiments, the method further comprises depositing material corresponding to consecutive layers of the pattern until the structure is complete.

In some embodiments, imaging the first material layer further comprises imaging the first material layer during material deposition and after material deposition is complete.

In some embodiments, comparing the properties of the first material layer further comprises comparing the properties of the first material layer with the model structure pattern to generate information for use in the execution of further material deposition.

In some embodiments, the information is used to form new structures.

In some embodiments, the method of forming a structure by depositing material onto a work piece further comprises altering the first material layer to fit within acceptable specified tolerances when it is determined that the first material layer falls outside of acceptable specified tolerances.

In an embodiment, an apparatus is provided for performing beam processing of a workpiece, the apparatus comprising:
a beam system for producing a directed beam,
one or more beam lenses for directing and focusing said beam,
a deposition precursor injection system, and
a controller for controlling said apparatus, said controller receiving instructions from a computer system, said computer system being programmed to carry out the following steps of:
   providing a model structure pattern having features and converting the model structure pattern into a series of layers;
   calculating a beam scan strategy and system parameters based on the geometry of each layer;
   directing the charged particle beam to deposit material corresponding to the features of the pattern,
   directing the charged particle beam to image the structure;
   characterized by comparing the properties of the structure with the model structure pattern to determine that the quality of the structure based on a predetermined set of values fits within acceptable specified tolerances

In some embodiments, the apparatus further comprises adjusting any of the system parameters to produce a structure that fits within acceptable specified tolerances and depositing material using the adjusted parameters corresponding to the structure pattern.

In some embodiments, the beam scan strategy comprises analyzing the structure pattern to determine the size of the features in the structure pattern, determining a beam path throughout the structure pattern, and determining the beam current required for each point in the structure pattern, wherein the beam current varies throughout the structure pattern.

In some embodiments, the computer system is further programmed to deposit image, and compare consecutive material layers until the structure is complete.

Although the present invention and its advantages have been described in detail, it should be understood that various changes, substitutions and alterations can be made to the embodiments described herein without departing from the invention as defined by the appended claims. Moreover, the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include such processes, machines, manufacture, compositions of matter, means, methods, or steps.

## Claims

1. A method of forming a structure by depositing material onto a work piece in a particle beam system, comprising:
providing a model structure pattern (200) having features (202, 204, 206);
converting the model structure pattern into a series of layers (1002);
calculating a beam scan strategy and system parameters (504) based on the geometry of each layer;
depositing material (506) corresponding to the first layer of the pattern;
imaging (508) the first material layer;
**characterized by**
comparing (510) the properties of the first material layer with the model structure pattern to determine that the quality of the first material layer based on a predetermined set of values that fits within acceptable specified tolerances.

2. The method of claim 1, further comprising adjusting any system parameters required to produce a first material layer that fits within acceptable specified tolerances and depositing material using the adjusted parameters corresponding to the first layer of the pattern.

3. The method of claims 1 or 2, further comprising depositing, imaging, and comparing consecutive material layers until the structure is complete.

4. The method of claim 3, further comprising adjusting any system parameters for each consecutive layer required to produce a material layer that fits within acceptable specified tolerances and depositing each consecutive layer using the adjusted parameters corresponding to each layer.

5. The method of any of the preceding claims, wherein the system parameters include at least one of beam current, beam density, dwell time, vacuum level, and temperature.

6. The method of claims 1, 2, 4-6, further comprising depositing material corresponding to consecutive layers of the pattern until the structure is complete.

7. The method of any of the preceding claims, in which imaging the first material layer further comprises imaging the first material layer during material deposition (708a) and after material deposition is complete (708b).

8. The method of any of the preceding claims, in which comparing the properties of the first material layer further comprises comparing the properties of the first material layer with the model structure pattern to generate information for use in the execution of further material deposition.

9. The method of claim 8, wherein the information is used to form consecutive layers in the structure.

10. The method of claim 8, wherein the information is used to form new structures.

11. The method of any of the preceding claims, further comprising altering the first material layer to fit within acceptable specified tolerances when it is determined that the first material layer falls outside of acceptable specified tolerances.

12. An apparatus for performing beam processing of a workpiece, the apparatus comprising:
a beam system (102) for producing a directed beam (152),
one or more beam lenses (151, 154) for directing and focusing said beam,
a deposition precursor injection system (130), and
a controller (138) for controlling said apparatus, said controller receiving instructions from a computer system, said computer system being programmed to carry out the following steps of:
providing a model structure pattern having features and converting the model structure pattern into a series of layers;
calculating a beam scan strategy and system parameters based on the geometry of each layer;
directing the charged particle beam to deposit material corresponding to the features of the pattern,
directing the charged particle beam to image the structure;
**characterized by**
comparing the properties of the structure with the model structure pattern to determine that the quality of the structure based on a predetermined set of values fits within acceptable specified tolerances.

13. The apparatus of claim 12, further comprising adjusting any of the system parameters to produce a structure that fits within acceptable specified tolerances and depositing material using the adjusted parameters corresponding to the structure pattern.

14. The apparatus of claims 12 or 13, wherein the beam scan strategy comprises analyzing the structure pattern to determine the size of the features in the structure pattern, determining a beam path throughout the structure pattern, and determining the beam current required for each point in the structure pattern, wherein the beam current varies throughout the structure pattern.

15. The apparatus of claims 12-14, wherein the computer system is further programmed to deposit, image, and compare consecutive material layers until the structure is complete.
